# EUROPÄISCHE PATENTSCHRIFT

(11) **EP 3 150 035 B1**
(45) Veröffentlichungstag und Bekanntmachung des Hinweises auf die Patenterteilung: **16.09.2020**
(21) Anmeldenummer: 15725316.2
(22) Anmeldetag: 26.05.2015
(51) Int. Cl.: H05K 7/14, H05K 5/00, H05K 7/20

(54) **MODULAR AUFGEBAUTES ELEKTRISCHES GERÄT**
ELECTRIC DEVICE WITH A MODULAR DESIGN
APPAREIL ÉLECTRIQUE À CONCEPTION MODULAIRE

(30) Priorität: 28.05.2014 DE 102014008050
(43) Veröffentlichungstag der Anmeldung: 05.04.2017
(73) Patentinhaber: KOSTAL Automobil Elektrik GmbH & Co. KG, 58513 Lüdenscheid (DE)
(72) Erfinder: BÜHLMANN, Rainer, 59439 Holzwickede (DE); KEBEKUS, Daniel, 44579 Castrop-Rauxel (DE); FOCKENBERG, Fabian, 48249 Dülmen (DE)
(74) Vertreter: Kerkmann, Detlef
(86) Internationale Anmeldenummer: PCT/EP2015/061589
(87) Internationale Veröffentlichungsnummer: WO 2015/181168

(56) Entgegenhaltungen:
- DE-U1-202005 014 761
- US-A1- 2003 133 257

## Beschreibung

Die Erfindung betrifft ein modular aufgebautes elektrisches Gerät, aufweisend ein elektrisches Leistungsmodul und ein elektrisches Steuerungsmodul zur elektrischen Steuerung des Leistungsmoduls, wobei das Leistungsmodul und das Steuerungsmodul miteinander verbundene oder miteinander verbindbare Gehäuse aufweisen, welche äußere Gehäuseflächen aus Metall und aus Kunststoff aufweisen, wobei das Gehäuse des Steuerungsmoduls eine offene Seite aufweist, die durch eine Metallplatte abgeschlossen ist, wobei das Gehäuse des Leistungsmoduls als ein Hohlkörper aus einem Metall ausgebildet ist, der eine offene Seite aufweist, und wobei nach dem Zusammenfügen der Gehäuse des Steuerungsmoduls und des Leistungsmoduls die am Steuerungsmodul angeordnete Metallplatte die offene Seite des Gehäuses des Leistungsmoduls verschließt.

Ein derartiges modular aufgebautes elektrisches Gerät ist aus der US-Offenlegungsschrift US2003/0133257 bekannt.

Für viele Anwendungsfälle ist es zweckmäßig und vorteilhaft, elektrische Geräte modular aufzubauen. Hierbei wird ein Gerät aus mehreren separat gefertigten Gerätekomponenten (Modulen) zusammengesetzt. Einer der Vorteile eines modularen Aufbaus besteht darin, dass die einzelnen Gerätekomponenten in mehreren Varianten gestaltet sein können, die dann verschiedenartig miteinander kombinierbar sind.

Ebenfalls vorteilhaft ist, dass elektrische Geräte, die Bestandteile mit deutlich unterschiedlichen elektrischen Eigenschaften aufweisen (zum Beispiel ein Hochfrequenzteil und ein Niederfrequenzteil oder ein Leistungsteil und ein Steuerungsteil), welche sich gegenseitig störend beeinflussen können, sich in separate Baueinheiten aufteilen lassen, die jeweils gut gegen Störeinflüsse abschirmbar sind.

Aus der deutschen Gebrauchsmusterschrift DE 20 2005 014 761 U1 ist ein modular aufgebautes elektrisches Ladegerät für Batterien bekannt, das wenigstens ein Leistungsmodul aufweist, welches mit weiteren Leistungsmodulen oder mit anderen Ladegerätekomponenten verbindbar ist. Aus diesem Dokument gehen allerdings nur wenige Details zur konkreten konstruktiven Ausgestaltung eines solchen Geräts hervor.

Leistungsmodule verarbeiten und schalten üblicherweise relativ hohe elektrische Stromstärken und/oder Leistungen, wobei leistungsstarke und breitbandige Störimpulse entstehen können.

Typisch für Steuerungsmodule sind dagegen relativ kleine Spannungen und Stromstärken sowie hohe Schaltfrequenzen und vergleichsweise komplex aufgebaute Schaltkreise. Störimpulse aus Leistungsmodulen können in solche Steuerungsmodule Spannungen einstreuen, die die Funktionen des Steuerungsmoduls beeinträchtigen. Sowohl die Ausbreitung als auch die Einstreuung von Störimpulsen kann durch die Verwendung von Metallgehäusen verhindert werden. Allerdings führt eine vollständige Einkapselung aller Module eines elektrischen Geräts in geschlossene Metallgehäuse zu sehr kostenaufwendigen und schweren Aufbauten.

Aus der DE 101 62 600 A1 ist eine Gehäuseanordnung für ein elektrisches Gerät bekannt, welches zwei miteinander verbundene Gehäuseteile aufweist, von denen das eine aus einem Kunststoff und das andere aus einem Metall besteht. Zwischen diesen Gehäuseteilen ist eine Leiterplatte eingespannt, welche eine metallisierte Fläche aufweist. Die metallisierte Fläche bildet zusammen mit dem metallenen Gehäuseteil einen faradayschen Käfig aus, der in dessen Inneren angeordnete Bauelemente gegen äußere Störstrahlung abschirmt. Innerhalb des so gebildeten abgeschlossenen Metallgehäuses sind störstrahlungsempfindlichen Bauteile angeordnet. Leistungsbauteile sind auf der anderen Seite der Leiterplatte platziert, die von einem Kunststoffgehäuse umschlossen ist. Eine mögliche Abstrahlung von Störimpulsen durch die Leistungsbauteile wird in diesem Dokument nicht thematisiert.

Die Gehäuseseite aus Kunststoff ermöglicht es, das Volumen des Gerätegehäuses zu vergrößern, ohne dass dabei das Gewicht des Gerätes übermäßig ansteigt. Die beschriebene Gehäuseanordnung weist damit Gehäuseteile aus verschiedenen Materialien auf, zeigt aber hinsichtlich der Funktionseinheiten keinen modularen Aufbau, da alle elektrischen Bauteile auf der von beiden Gehäuseteilen gehaltenen Leiterplatte angeordnet sind.

Es stellte sich die Aufgabe, ein modular aufgebautes Gerät mit einer verbesserten Leistungsfähigkeit zu schaffen, welches sich durch gute elektromagnetische Verträglichkeit und ein relativ geringes Gewicht auszeichnet und das einen vergleichsweise einfachen und kostengünstigen Aufbau aufweist.

Diese Aufgabe wird erfindungsgemäß durch das Gerät nach Anspruch 1 gelöst.

Das erfindungsgemäß als elektrisches Ladegerät ausgeführte elektrische Gerät weist als unterscheidbare Modulkomponenten ein Leistungsmodul und ein Steuerungsmodul auf, wobei die Bauteile des Steuerungsmoduls in einem Kunststoffgehäuse angeordnet sind, welches durch eine Metallplatte abgeschlossen ist. Die üblicherweise hochkomplexen Schaltungskomponenten des Steuerungsmoduls sind durch das geschlossene Gehäuse bereits in diesem Montagestadium gut gegen Umwelteinflüsse geschützt.

Die zum Leistungsmodul gehörenden Bauelemente sind in einem als metallener Hohlkörper ausgebildeten Gehäuse montiert und elektrisch miteinander verschaltet. Eine Gehäuseseite des Leistungsmoduls bleibt nach der Montage der Bauelemente zunächst offen. Erst beim Zusammenfügen des Leistungsmoduls mit dem Steuerungsmodul wird die offene Gehäuseseite des Leistungsmoduls durch die am Gehäuse des Steuerungsmoduls angeordnete Metallplatte verschlossen. Form und Größe der Metallplatte sind dabei vorzugsweise genau so groß gewählt, dass sie beim Anfügen an das Leistungsmodul die offene Gehäuseseite des Leistungsmoduls bündig abschließt.

Zwei Ausführungsbeispiele der Erfindung sind in der Zeichnung skizzenhaft dargestellt und werden im Folgenden anhand der Zeichnung näher erläutert. Die Figuren 1 und 2 stellen jeweils eine Ausführung eines modular aufgebauten Geräts dar. Die Figur 3 zeigt ein Steuerungsmodul als Einzelteil.

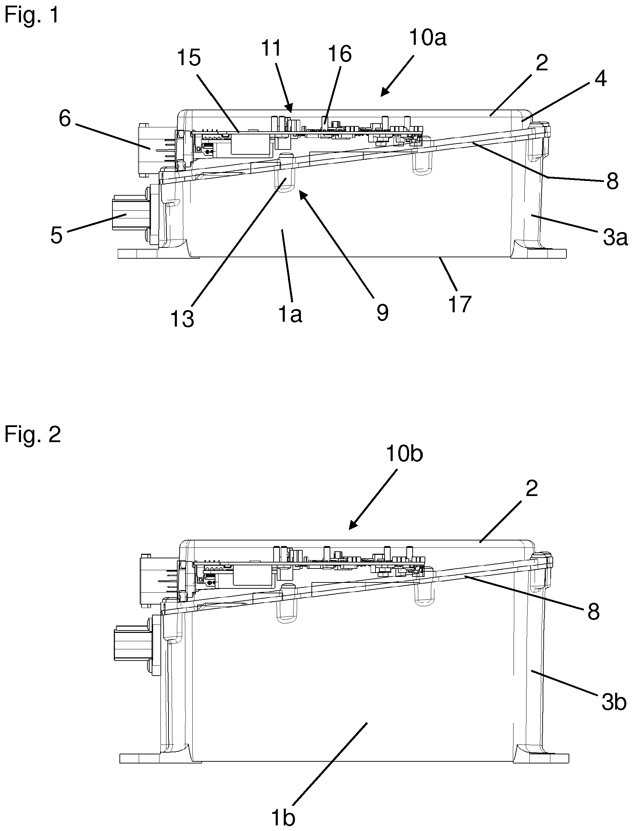

Die Figur 1 zeigt ein erstes Ausführungsbeispiel eines erfindungsgemäßen modular aufgebauten Geräts 10a. Das Gerät 10a besteht aus einem Leistungsmodul 1a und einem Steuerungsmodul 2, deren Gehäuse 3a, 4 über mehrere Schraubverbindungen 9 aneinander befestigt sind. Das Gehäuse 4 des Steuerungsmoduls 2 ist im Gegensatz zum Gehäuse 3a des Leistungsmoduls 1a transparent dargestellt, so dass eine im Inneren des Steuerungsmodulgehäuses 4 angeordnete Leiterplatte 15 mit - hier nicht näher spezifizierten - elektronischen Bauelementen 16 erkennbar ist, welche zusammen eine Steuerungselektronik 11 ausbilden.

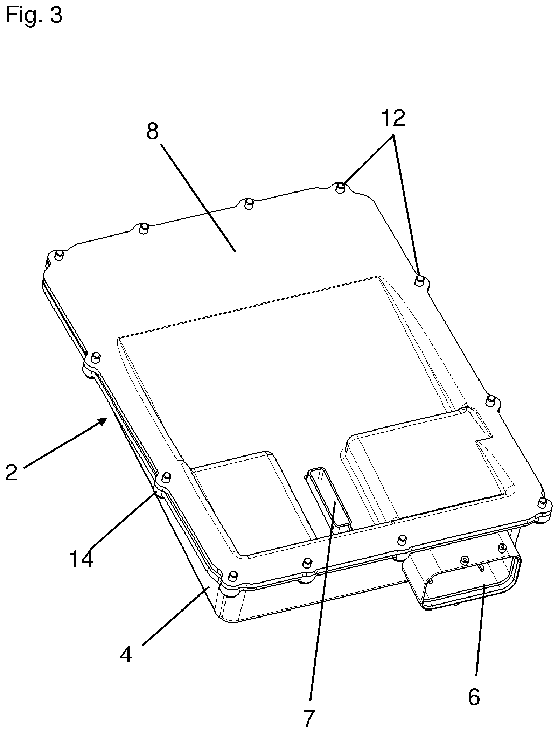

Die Steuerungselektronik 11 dient zur elektrischen Steuerung einer in das Leistungsmodulgehäuse 3a eingebauten Leistungselektronik, die in der Zeichnung nicht bildlich dargestellt ist. Die elektrische Verbindung zwischen dem Steuerungsmodul 2 und dem Leistungsmodul 1a erfolgt über einen in der Figur 3 dargestellten Steckverbinder 7, der an der Unterseite des Steuerungsmoduls 2 angeordnet ist. Mit elektrischen Anlagen seiner Umgebung kann das Leistungsmodul 1a über einen an einer Außenseite des Leistungsmodulgehäuses 3a angebrachten Anschlussstecker 5 verbunden werden.

Die Steuerungselektronik 11 steht außerdem mit den Kontaktelementen eines am Steuerungsmodulgehäuse 4 angeordneten Schnittstellenanschlusses 6 in elektrischer Verbindung. Über diesen Schnittstellenanschluss 6 kann die Steuerungselektronik 11 Signale oder Daten mit der Umgebung austauschen und/oder von außen mit einer elektrischen Spannung versorgt werden.

Die mechanische Verbindung zwischen den Gehäusen 3a, 4 des Leistungsmoduls 1a und des Steuerungsmoduls 2 verläuft schräg zur Bodenfläche 17 des Leistungsmoduls 1a. Um einen insgesamt etwa quaderförmigen Aufbau des Geräts 10a zu erreichen, weist das Steuerungsmodulgehäuse 4 ein etwa keilförmiges Längsprofil auf. Diese Formgebung ermöglicht es, an einer Seitenfläche des Steuerungsmoduls 2 ausreichend Platz zur Anbringung des Schnittstellenanschlusses 6 bereitzustellen und dabei zugleich das Volumen des Steuerungsmodulgehäuses 4 relativ klein zu halten.

Die keilförmige Bauform des Steuerungsmodulgehäuses 4 begünstigt zudem eine einfache Montage der Leiterplatte 15, und zwar besonders dann, wenn die Kontakte des Schnittstellenanschlusses 6 direkt an der Leiterplatte 15 angebunden sind. Dabei erleichtert es die niedrige Rückwand des Steuerungsmodulgehäuses 4, die Leiterplatte 15 in das Steuerungsmodulgehäuse 4 einzuschieben.

Eine solche keilförmige Ausgestaltung des Steuerungsmoduls 2 ist daher vorteilhaft, aber zur Ausführung der Erfindung selbstverständlich nicht zwingend vorzusehen.

Wie bereits erwähnt enthält das Leistungsmodulgehäuse 3a eine hier nicht bildlich dargestellte Leistungselektronik. Diese kann außer Leistungshalbleitern auch Drosseln, Transformatoren oder ähnliche Bauteile aufweisen, sowie auch Kühlkörper zum Abführen der elektrischen Verlustwärme dieser Komponenten. Die Abmessungen dieser Bauteile hängen wesentlich von der Größe einer umzusetzenden Nutz- und auch Verlustleistung ab, so dass der vorgesehene Leistungsumsatz des Leistungsmoduls die Abmessungen des Leistungsmodulgehäuses 3a mitbestimmt.

Die Figur 2 zeigt dem entsprechend ein weiteres modular aufgebautes elektrisches Gerät 10b, welches für einen höheren Leistungsumsatz ausgelegt ist und daher ein im Vergleich zu dem in der Figur 1 abgebildeten Gerät 10a ein größeres Leistungsmodulgehäuses 3b aufweist.

Vorteilhafterweise können für beide in den Figuren 1 und 2 dargestellten Leistungsmodule 1a und 1b jeweils identisch ausgeführte Steuerungsmodule 2 eingesetzt werden. Hierdurch betreffen Anpassungen des elektrischen Geräts 10a, 10b an unterschiedliche Leistungsumsätze jeweils nur die Ausführung der Leistungsmodule 1a, 1b, während die Ausführung der Steuerungsmodule 2 unverändert bleiben kann. Die Steuerungsmodule 2 können so in einer einheitlichen Ausführung in hohen Stückzahlen besonders kostengünstig gefertigt werden.

Eine einheitliche mechanische Verbindung zwischen identisch gestalteten Steuerungsmodulen 2 und unterschiedlichen großen Leistungsmodulen 1a, 1b wird auf einfache Weise dadurch erreicht, dass sich die Gehäuse 3a, 3b der Leistungsmodule 1a, 1b lediglich in ihren Abmessungen in vertikaler Richtung unterscheiden, so dass der Gesamtaufbau der Geräte 10a und 10b, abgesehen von einer unterschiedlichen Bauhöhe, äußerlich gleich ist.

Die Figur 3 zeigt die Unterseite eines einzeln dargestellten Steuerungsmoduls 2. Erkennbar ist eine Metallplatte 8, aus der die Endabschnitte mehrerer Schrauben 12 herausragen. Diese Schrauben 12 sind jeweils durch eine Anschraublasche 14 am Steuerungsmodulgehäuse 4 und danach durch Bohrungen in der Metallplatte 8 hindurchgeführt. Beim Zusammenbau des elektrischen Gerätes 10a bzw. 10b werden die Endabschnitte der Schrauben 12 in am Leistungsmodulgehäuse 3a bzw. 3b angeformte Schraubhülsen 13 eingeschraubt. Vor dem Anfügen an das Leistungsmodulgehäuse 3a, 3b kann die Metallplatte 8 bereits am Steuerungsmodulgehäuse 4 vormontiert sein, beispielsweise über eine in den Figuren nicht dargestellte Klipsverbindung.

Nach dem Zusammenschrauben ist der in der Figur 1 bzw. der Figur 2 dargestellte Montagezustand hergestellt. Das Steuerungsmodul 2 und das verwendete Leistungsmodul 1a, 1b sind durch, bei Bedarf auch wieder lösbare, Schraubverbindungen 9 fest miteinander verbunden. Die Metallplatte 8 befindet sich nun genau zwischen dem Steuerungsmodul 2 und dem Leistungsmodul 1a, 1b und schließt damit die Öffnungen beider Modulgehäuse 3a bzw. 3b, 4 störstrahlungssicher ab.

Besonders vorteilhaft hierbei ist, dass die Bauteile des Leistungsmoduls 1a, 1b nun vollständig von Metallflächen umgeben sind, wodurch eine störstrahlungssichere Einkapselung aller Bauteile des Leistungsmoduls 1a, 1b erreicht wird. Ausgenommen hiervon ist lediglich der kleine Bereich am Ort des Steckverbinders 7, der zur Herstellung einer elektrischen Verbindung zwischen dem Steuerungsmodul 2 und dem Leistungsmodul 1a, 1b erforderlich ist. Der Steckverbinder 7 wir dazu vor dem Zusammenfügen der Gehäuse 3a bzw. 3b, 4 mit einem komplementär ausgebildeten Gegensteckverbinder am Leistungsmodul 1a, 1b oder mit einer entsprechend geformten Steckerkupplung zusammengesteckt. Durch eine geeignet geschirmte Ausführung des Steckverbinders 7 können Störstrahlungseinkopplungen auch an der Steckverbindung zwischen den Modulen 1a, 1b, 2 sehr gering gehalten werden.

Das in diesen Ausführungsbeispielen dargestellte elektrische Gerät 10a, 10b kann beispielsweise ein Ladegerät ausbilden, welches an Bord eines elektrisch angetriebenen Fahrzeugs verwendet wird.

### Bezugszeichen

- 1a, 1b: Leistungsmodul
- 2: Steuerungsmodul
- 3a, 3b: Leistungsmodulgehäuse
- 4: Steuerungsmodulgehäuse
- 3a, 3b, 4: Gehäuse (zusammenfassend)
- 5: Anschlussstecker
- 6: Schnittstellenanschluss
- 7: Steckverbinder
- 8: Metallplatte
- 9: Schraubverbindungen
- 10a, 10b: Gerät
- 11: Steuerungselektronik
- 12: Schrauben
- 13: Schraubhülsen
- 14: Anschraublasche
- 15: Leiterplatte
- 16: Bauelemente
- 17: Bodenfläche

## Patentansprüche

1. Modular aufgebautes elektrisches Gerät (10a, 10b),
aufweisend ein elektrisches Leistungsmodul (1a, 1b) und ein elektrisches Steuerungsmodul (2) zur elektrischen Steuerung des Leistungsmoduls (1a, 1b),
wobei das Leistungsmodul (1a, 1b) und das Steuerungsmodul (2) miteinander verbundene oder miteinander verbindbare Gehäuse (3a, 3b, 4) aufweisen,
wobei das modular aufgebaute elektrische Gerät (10a, 10b) äußere Gehäuseflächen aus Metall und aus Kunststoff aufweist,
wobei das Gehäuse (4) des Steuerungsmoduls (2) eine offene Seite aufweist, die durch eine Metallplatte (8) abgeschlossen ist,
wobei das Gehäuse (3a, 3b) des Leistungsmoduls (1a, 1b) als ein Hohlkörper aus einem Metall ausgebildet ist, der eine offene Seite aufweist,
und wobei nach dem Zusammenfügen der Gehäuse (4, 3a, 3b) des Steuerungsmoduls (2) und des Leistungsmoduls (1a, 1b) die am Steuerungsmodul (2) angeordnete Metallplatte (8) die offene Seite des Gehäuses (3a, 3b) des Leistungsmoduls (1a, 1b) verschließt,
**dadurch gekennzeichnet,**
**dass** das Gerät (10a, 10b) ein elektrisches Ladegerät ist und dass das Gehäuse (4) des Steuerungsmoduls (2) als ein Hohlkörper aus einem Kunststoff ausgebildet ist.

2. Gerät nach Anspruch 1, **dadurch gekennzeichnet, dass** durch die Metallplatte (8) ein elektrischer Steckverbinder (7) hindurchgeführt ist.

3. Gerät nach Anspruch 1, **dadurch gekennzeichnet, dass** unterschiedlich ausgeführte Leistungsmodule (1a, 1b) mit einem jeweils einheitlich ausgeführten Steuerungsmodul (2) zu einem elektrischen Gerät (10a, 10b) zusammenfügbar sind.

4. Gerät nach Anspruch 3, **dadurch gekennzeichnet dass** sich unterschiedlich ausgeführte Leistungsmodule (1a, 1b) untereinander durch ihre Bauhöhe und ihre elektrische Anschlussleistung unterscheiden.

## Claims

1. An electrical device (10a, 10b) constructed in modular form,
with an electric power module (1a, 1b) and an electrical control module (2) to provide electrical control to the power module (1a, 1b),
whereby the power module (1a, 1b) and the control module (2) have housings (3a, 3b, 4) which are linked or can be linked to each other, wherein the modular electrical device (10a, 10b) has outer housing surfaces made of metal and plastic,
whereby the housing (4) of the control module (2) has an open side which is closed by a metal, plate (8),
whereby the housing (3a, 3b) of the power module (1a, 1b) is formed as a hollow body in metal with an open side,
and whereby, after the housings (4, 3a, 3b) of the control module (2) and the power module (1a, 1b) have been fitted together, the metal plate (8) to the control module (2) closes the open side of the housing (3a, 3b) of the power module (1a, 1b),
**characterized by the fact that**
the device (10a, 10b) is an electrical charging device and the housing (4) of the control module (2) is formed as a hollow body made of plastic.

2. A device as in Claim 1, **characterized by** the fact that an electrical plug connector (7) passes through the metal plate (8).

3. A device as in Claim 1, **characterized by** the fact that differently formed power modules (1a, 1b) with its united control module (2) can be fitted together to form an electrical device (10a, 10b).

4. A device as in Claim 3, **characterized by** the fact that the differently formed power modules (1a, 1b) differ from each other in their build height and their connected electrical power.

## Revendications

1. Appareil électrique de conception modulaire (10a, 10b) présentant un module de puissance électrique (1a, 1b) et un module de commande électrique (2) destiné à la commande électrique du module de puissance (1a, 1b),
sachant que le module de puissance (1a, 1b) et le module de commande (2) présentent des boitiers (3a, 3b, 4), qui sont ou peuvent être reliés ensemble,
sachant que l'appareil électrique de conception modulaire (10a, 10b) présente des surfaces extérieures de boitier en métal et en matière synthétique,
sachant que le boitier (4) du module de commande (2) présente un côté ouvert, qui est fermé par une plaque métallique (8),
sachant que le boitier (3a, 3b) du module de puissance (1a, 1b) est réalisé sous la forme d'un corps creux en métal, qui présente un côté ouvert,
et sachant que, après l'assemblage des boitiers (4, 3a, 3b) du module de commande (2) et du module de puissance (1a, 1b), la plaque métallique (8), disposée sur le module de commande (2), ferme le côté ouvert du boitier (3a, 3b) du module de puissance (1a, 1b),
**caractérisé en ce que**,
l'appareil (10a, 10b) est un chargeur et que le boitier (4) du module de commande (2) est réalisé sous la forme d'un corps creux à partir d'une matière synthétique.

2. Appareil selon la revendication 1, **caractérisé en ce qu'**un connecteur électrique, enfichable (7) peut être conduit à travers la plaque métallique (8).

3. Appareil selon la revendication 1, **caractérisé en ce que** des modules de puissance (1a, 1b) de conception différente peuvent être assemblés chacun avec un module de puissance de conception uniforme (2) pour former un appareil électrique (10a, 10b).

4. Appareil selon la revendication 3, **caractérisé en ce que** des modules de puissance (1a, 1b) de conception différente se distinguent les uns des autres par leur hauteur de construction et leur puissance électrique connectée.
